# Europäisches Patentamt

## European Patent Office

## Office européen des brevets

(19)

(11) Veröffentlichungsnummer: **0 013 302**
**B1**

(12) **EUROPÄISCHE PATENTSCHRIFT**

(45) Veröffentlichungstag der Patentschrift:
02.03.83

(21) Anmeldenummer: 79104234.4

(22) Anmeldetag: 31.10.79

(51) Int. Cl.³: **G 11 C 11/40**, G 11 C 11/24,
**H 01 L 27/02**

(54) Verfahren und Schaltungsanordnung zum Betreiben eines integrierten Halbleiterspeichers.

(30) Priorität: 22.12.78 DE 2855866

(43) Veröffentlichungstag der Anmeldung:
23.07.80 Patentblatt 80/15

(45) Bekanntmachung des Hinweises auf die Patenterteilung:
02.03.83 Patentblatt 83/9

(84) Benannte Vertragsstaaten:
AT DE FR GB NL SE

(56) Entgegenhaltungen:
EP-A-0 004 871
US-A-3 540 010
US-A-3 736 574
US-A-3 786 442
US-A-3 789 243
US-A-4 021 786
US-A-4 032 902
US-A-4 090 255
US-A-4 112 511
US-A-4 122 542
US-A-4 122 548
ELECTRONICS, Band 47, Nr. 9, 2. Mai 1974, Seiten
110—114 New York, U.S.A. GERSBACH: »Current
steering simplifies and shrinks 1k bipolar RAM«.

(73) Patentinhaber: International Business Machines
Corporation, Armonk, N.Y. 10504 (US)

(72) Erfinder: Heuber, Klaus, Taunusstrasse 62,
D-7030 Böblingen (DE)
Erfinder: Wiedmann, Siegfried, Dr., Im Himmel 64A,
D-7000 Stuttgart 80 (DE)

(74) Vertreter: Rudolph, Wolfgang, Schönaicher Strasse 220,
D-7030 Böblingen (DE)

IBM TECHNICAL DISCLOSURE BULLETIN, Band
13, Nr. 6, November 1970, Seiten 1705—1706
Armonk, U.S.A. WIEDMANN et al.: »Restore
Circuitry for Bit/Sense System.
IEEE JOURNAL OF SOLID-STATE CIRCUITS,
Band SC 13, Nr. 5, Oktober 1978, Seiten 656—663
New York, U.S.A. KAWARADA et al.: »A Fast 7.5
ns Acess 1K-Bit RAM for Cache-Memory Systems.
IBM TECHNICAL DISCLOSURE BULLETIN, Band
21, Nr. 1, Juni 1978, Seiten 231—232 Armonk,
U.S.A. WIEDMANN: »MTL Storage Cell«.
IEEE JOURNAL OF SOLID-STATE CIRCUITS,
Band SC 6, Nr. 5, Oktober 1971, Seiten 297—300
New York, U.S.A. »Bipolar Dynamic Memory
Cell«.

## Verfahren und Schaltungsanordnung zum Betreiben eines integrierten Halbleiterspeichers

Die Erfindung betrifft Verfahren zum Betreiben eines integrierten Halbleiterspeichers nach dem Oberbegriff der Patentansprüche 1 und 2 und eine Schaltungsanordnung zur Durchführung des Verfahrens.

Durch die DE-PS 2 511 518 sind ein Verfahren und eine Schaltungsanordnung zum Betreiben eines integrierten Halbleiterspeichers bekannt, dessen Speicherzellen aus Flip-Flops mit bipolaren Transistoren und Schottky-Dioden als Lese-/Schreib-Ankoppelelemente bestehen und die als Lastelemente hochohmige Widerstände oder als Stromquellen geschaltete Transistoren benutzen, deren Schreib-/Lese-Zyklen jeweils in mehreren Phasen ablaufen und die durch Pegeländerungen auf Wortleitungen und Bitleitungen selektiert werden, die zum Erhöhen der Schreibgeschwindigkeit und der Lesegeschwindigkeit sowie zum Verringern der Verlustleistung die Entladung der Bitleitungen über die leitenden Speicherzellentransistoren vornehmen. Das Entladen der Bitleitungen über die leitenden Speicherzellentransistoren erfolgt nach Masse, und während der Lesephase des Speichers werden die Bitleitungen nur geringfügig umgeladen, so daß der Umladestrom, der durch die Speicherzelle fließt, sehr klein ist.

Auf dem Gebiet der logischen Verknüpfungsschaltungen und Speichertechnik mit bipolaren Transistoren hat in den letzten Jahren eine rege Entwicklung stattgefunden, die in der Fachwelt große Aufmerksamkeit erregt hat und unter der Bezeichnung MTL (merged transistor logik) oder auch I²L (integrated injection logik) Eingang in die Fachliteratur gefunden hat. Es wird beispielsweise auf die Aufsätze im IEEE Journal of Solid-State Circuits, Band SC/7 Nr. 5, Oktober 1972, Seiten 340 ff. und 346 ff. verwiesen. Entsprechende Vorschläge wurden in den US-PS 37 36 477 und 38 16 758 gemacht. Diese Konzepte mit bipolaren Transistoren zeichnen sich durch kurze Schaltzeiten aus und sind zum Aufbau von extrem hochintegrierten Speichern und logischen Schaltungsverbänden geeignet. Aus der DE-OS 2 307 739 ist eine derartige Speicherzelle bekanntgeworden, die aus zwei logischen Schaltungen zusammengesetzt ist und bei der der Kollektor des invertierenden Transistors der einen Schaltung jeweils mit der Basis des invertierenden Transistors der anderen Schaltung gekoppelt ist. Die beiden Transistoren werden wiederum invers betrieben und bilden die eigentlichen Flip-Flop-Transistoren. Als Lastelement für beide Flip-Flop-Transistoren dient der über eine gesonderte Leitung angeschlossene komplementäre Transistor jeder Grundschaltung, über den die Injektion der Minoritätsladungsträger, also die Stromversorgung erfolgt. Zum Zwecke der Adressierung, d. h. zum Einschreiben und Lesen der Speicherzelle, ist zusätzlich die Basis jedes Flip-Flop-Transistors mit dem Emitter des zugeordneten zusätzlichen, ebenfalls komplementären Adressier-Transistors verbunden, dessen Kollektor an der zugeordneten Bitleitung und dessen Basis an der Adreßleitung liegt. Da hier ein zusätzlicher Transistor vorhanden ist, wurde aus der DE-OS 2 612 666 zum Aufbau von Speicherzellen eine hochintegrierte, invertierende logische Schaltung mit einer, einen invertierenden Transistor bildenden Zonenfolge bekannt, der über ein Injektionsgebiet in der Nähe des Basis-Emitterübergangs durch Injektion von Ladungsträgern mit Betriebsstrom und an der Basis gesteuert wird, der dadurch charakterisiert ist, daß an das Injektionsgebiet eine Abfühlschaltung angeschlossen ist, über die der Leitzustand des invertierenden Transistors aufgrund des bei leitendem Transistor in das Injektionsgebiet rückinjizierten Stromes abgefühlt wird.

Speicher, die aus MTL-Speicherzellen aufgebaut sind, machen bei der Selektion einer Zelle die Umladung von Bitdaten- und/oder Steuerleitungskapazitäten notwendig. Der Spannungshub der Bitleitungen entspricht dabei ungefähr dem Spannungshub der selektierten Wortleitung. Wie bereits in der DE-PS 2 511 518 beschrieben, werden die kapazitiven Entladeströme über die Speicherzellen der selektierten Wortleitung und über den Wortleitungstreiber nach Masse abgeführt. Dies hat jedoch bei großer Anzahl von Speicherzellen innerhalb einer Matrix den Nachteil, daß der Flächenbedarf des Treiberschaltkreises, die elektrische Verlustleistung für jeden Treiber und die Verzögerungszeit bei der Selektion der Wortleitung unverhältnismäßig groß wird, so daß die Vorteile der MTL-Struktur dadurch wieder zunichte gemacht würden.

In der MTL-Technik ist die Zuführung der Ruheströme über die Bitleitungen im Ruhezustandsbetrieb erforderlich. Eine bei Matrixspeichern, z. B. US-A-3 789 243, übliche Vorladung während des gesamten Ruhezustandsbetriebs ist nicht möglich.

Der Erfindung liegt deshalb die Aufgabe zugrunde, ein Verfahren zum Betreiben eines Halbleiterspeichers nach dem Oberbegriff des Hauptanspruchs 1 oder 2 zu schaffen, das bei Erhöhung der Zugriffszeit den Leistungsbedarf wesentlich verringert und Spitzenströme auf den Versorgungsleitungen und an den Versorgungsspannungsquellen vermeidet sowie eine Schaltungsanordnung zur Durchführung dieses Verfahrens anzugeben.

Die erfindungsgemäßen Lösungen der Aufgabe sind im Kennzeichen der Patentansprüche 1 und 2 angegeben.

Schaltungsanordnungen zur Durchführung der Verfahren sind in den Ansprüchen 3 bis 7 angegeben.

Der Vorteil der vorgeschlagenen Betriebsweise besteht darin, daß bei sehr kleiner Zugriffs-/Zykluszeit im Nanosekundengebiet und ebenfalls sehr kleiner Verlustleistung im Milliwattgebiet für ein hochintegriertes MTL-Speicher-Chip im unselektierten Fall der DC-Masse-Strom wesentlich kleiner ist als der kapazitive Spitzenstrom, der über den Entladeschalter fließt. Fließt der Spitzenstrom nicht über die Spannungsversorgungsquellen, sondern er wird — wie in der vorgeschlagenen Betriebsweise — zur direkten Umladung der Bitleitungskapazitäten verwendet, dann treten dadurch keine Störspannungsprobleme auf den Versorgungsspannungen auf. Die vorgeschlagene Schaltung mit den Wortleitungs- und Bitleitungs-Schalttransistoren hat noch einen weiteren großen Vorteil. Wird der Entladestrom der Bitleitungskapazitäten nach Masse abgeführt, so muß der gleiche Strom von der Referenzspannungsquelle für die Wortleitungen zugeführt werden. Wird der Strom als DC-Strom zugeführt, so gelangt man zu einer nachteilig hohen Verlustleistung für das Speicher-Chip. Wird der Strom den Wortleitungskapazitäten selbst entnommen, so ist für die selektierte Wortleitung ein vergrößerter Spannungshub erforderlich, da durch die kapazitive Kopplung durch die Speicherzellen auch die unselektierten Wortleitungen, wenn auch verkleinert, einen Spannungshub ausführen. Zusätzlich vergrößerte Wortleitungskapazitäten verringern das Problem, erzeugen aber zusätzliche Verzögerungszeit bei der Wortleitungsselektion. Um dies zu vermeiden, werden nun die nicht selektierten Wortleitungen bei der Selektion einer Wortleitung mit vorhergehender Entladung der Bitleitungskapazitäten mit Hilfe der Schaltung im Potential konstant gehalten. Die Schaltung kommt ohne niederohmige Referenzquelle, ohne Erhöhung der Wortleitungskapazitäten und ohne Erhöhung des Spannungshubs auf den Wortleitungen aus. Dadurch wird die elektrische Verlustleistung wesentlich gesenkt. Für die vorgeschlagene Betriebsweise und auch für die Schaltung genügt der minimale Spannungshub für die selektierte Wortleitung, der notwendig ist, um die Speicherzellen, die an eine Bitleitung angeschlossen sind, genügend voneinander zu entkoppeln. Der minimale Spannungshub ist von der Anzahl der Speicherzellen und von deren Eingangskennlinie abhängig.

Die Erfindung wird nun an Hand von in der Zeichnung dargestellten Ausführungsbeispielen näher beschrieben. Es zeigt

Fig. 1 ein Ersatzschaltbild für die Kopplung von der selektierten Wortleitung auf die nicht selektierte Wortleitung, auf die Bitleitungen und die kapazitive Kopplung von den Bitleitungen auf die nicht selektierte Wortleitung innerhalb eines hochintegrierten Speichers mit Speicherzellen in MTL-Struktur,

Fig. 2 einen MTL-Speicher mit kleiner Verlustleistung, einem Entladeschaltkreis und einer Kontrollogik, mit eingezeichnetem Stromverlauf in der Entladephase und

Fig. 3 ein weiteres Ausführungsbeispiel eines hochintegrierten Speichers mit einem Entladeschaltkreis.

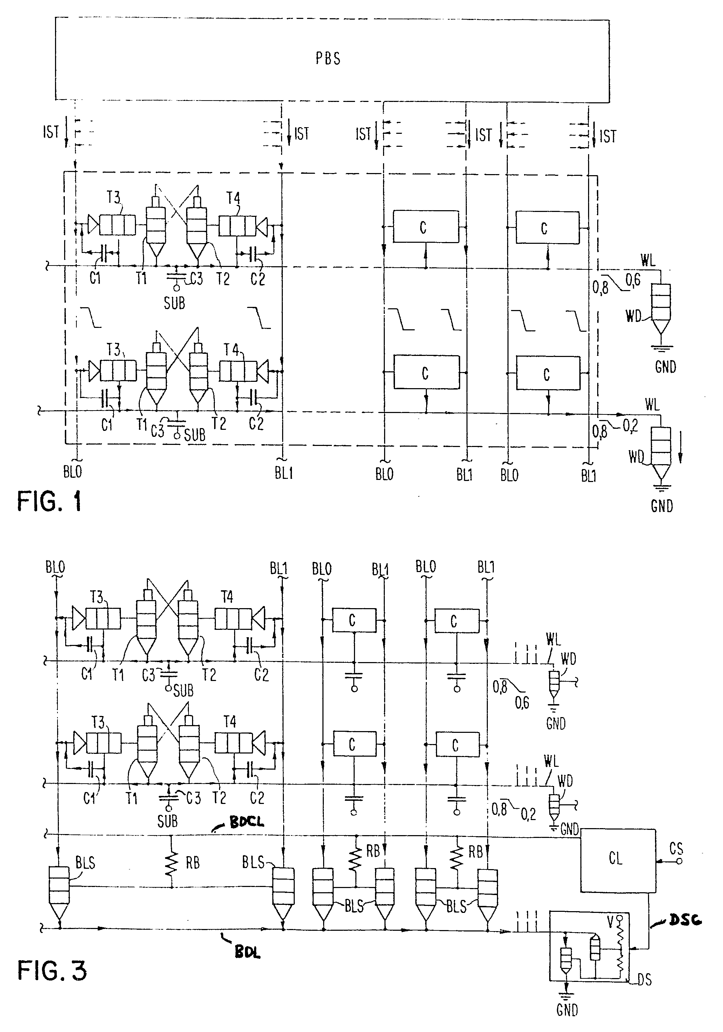

In Fig. 1 sind innerhalb einer Matrix MTL-Speicherzellen C dargestellt, die in den Kreuzungspunkten von Wortleitungen WL und Bitleitungspaaren, wie BL1 und BL0, liegen. An die Bitleitungen sind die peripheren Bitschaltkreise PBS angeschlossen, die den Ruhestrom IST liefern. Die Wortleitungen WL sind mit Wortleitungstreibern WD verbunden, deren Basis von einem nicht dargestellten Wortdecodierer angesteuert werden. Die MTL-Zellen selbst bestehen in diesem Beispiel aus zwei kreuzgekoppelten Transistoren T1 und T2, wobei das obere kleine Viereck als Topkollektor und das untere kleine Dreieck der inversen NPN-Transistoren als Subemitter bezeichnet werden soll. Die Basen der beiden Transistoren T1 und T2 sind jeweils mit dem Topkollektor verbunden, d. h. die Transistoren T1 und T2 sind kreuzgekoppelt. Die Subemitter der beiden Transistoren T1 und T2 sind mit der Wortleitung WL verbunden, an der auch die Basis-Elektroden der beiden PNP-Koppeltransistoren T3 und T4 angeschlossen sind. Ein Koppeltransistor liegt jeweils zwischen einer Bitleitung BL1 oder BL0 und der Basis eines der beiden Schalttransistoren T1 und T2. Außerdem sind in die beiden detailliert dargestellten Zellen der Fig. 1 die Streukapazitäten C1 und C2 zwischen den Bitleitungen BL1 und BL0 und der Wortleitung WL sowie die Streukapazität C3 zwischen dem Substrat SUB und der Wortleitung WL eingezeichnet. Diese Kapazitäten C1, C2 und C3 müssen bei der Selektion einer Speicherzelle C, die die Selektion einer Wortleitung WL erfordert, umgeladen werden. Diese kapazitiven Entladeströme könnten nun über die Speicherzellen C der selektierten Wortleitung und über den dazugehörigen Wortleitungstreiber nach Masse abgeführt werden. Jeder der vorhandenen Wortleitungstreiber WD müßte deshalb für den gesamten Entladungsstrom ausgeführt werden. Die Entladungsströme sind in Fig. 1 durch die Pfeilspitzen in den Leitungswegen dargestellt, wobei die Pfeilspitzen im oberen Bereich die Entladungsströme von weiteren nicht dargestellten Speicherzellen darstellen sollen und die Pfeilspitzen auf der Wortleitung den Entladestrom von anderen Speicherzellen C, die mit der gleichen Wortleitung verbunden sind. In Fig. 1 wird angenommen, daß die untere Wortleitung WL selektiert werden soll und die obere nicht selektiert wird. Es ist noch anzumerken, daß außer der untersten dargestellten Wortleitung keine der dargestellten und nicht dargestellten Wortleitungen im Speicherzellenverband selektiert sind. Zum Selektieren der untersten Wortleitung WL wird der Wortleitungstreiber WD1 von einem Signal vom nicht dargestellten Decodierer her eingeschaltet. Durch dieses Einschalten erfolgt auf der zugehörigen Wortleitung WL ein Spannungssprung — wie gezeichnet — vom oberen Pegel auf den unteren. Auf den Bitleitungen BL1 und BL0 folgt der Spannungsverlauf dem Spannungssprung auf der Wortleitung WL über die Ankoppeldiode von den Transistoren T3 bzw. T4 der selektierten Zellen. Dadurch entladen die kapazitiven Ströme die nicht selektierten Wortleitungen WL um einen gewissen Sprung. Der Differenzsprung zwischen selektierter Wortleitung und nicht selektierten Wortleitungen WL bewirkt die Entkopplung der Speicherzellen C an den nicht selektierten Wortleitungen.

Nach diesem Vorgang kann nun das Lesen bzw. Schreiben auf bekannte Art und Weise erfolgen. Der Vollständigkeit halber soll im nachfolgenden kurz eine Leseoperation und eine Schreiboperation beschrieben werden.

Zunächst wird über die nicht dargestellten Wort- bzw. Bitdecodierer die gewünschte Wortleitung WL über den dazugehörigen Wortleitungtreiber WD selektiert. Es soll nun angenommen werden, daß eine binäre Null eingeschrieben werden soll. Dazu wird dem Zellinjektor über die zugehörige Bitleitung BL0 der Schreibstrom von den peripheren Schaltkreisen zugeführt. Damit wird der Zell-NPN-Transistor auf der Seite der Bitleitung BL0 eingeschaltet und der andere Zelltransistor in den Auszustand abgesenkt. Die Null ist damit eingeschrieben. Das Einschreiben einer binären Eins erfolgt analog. Im nachfolgenden soll nur noch kurz der Lesevorgang beschrieben werden. Es wird angenommen, daß eine gespeicherte Null ausgelesen werden soll. Das heißt, daß der Zellinjektor, der an die Bitleitung BL0 über den Transistor T3 angeschlossen ist, eingeschaltet und der andere Zelltransistor T2 ausgeschaltet ist. Die gewünschte Wortleitung WL wird durch einen Treiber WD selektiert und die Leseströme werden über die Bitleitungen BL0 und BL1 eingeprägt; beide haben dabei die gleiche Größe. Daraufhin gibt die selektierte Speicherzelle ein Lesesignal ab, und zwar ist das Lesesignal auf der Bitleitung BL0 positiver als auf der Bitleitung BL1, was bedeutet, daß eine Null ausgelesen wurde. Zur Beendigung des Lesebzw. Schreibvorganges werden die Lese- bzw. Schreibströme abgeschaltet und die Spannungspegel auf den Wortleitungen WL und auf den Bitleitungen BL0 und BL1 werden wieder auf das hohe Ruhestandspotential zurückgebracht.

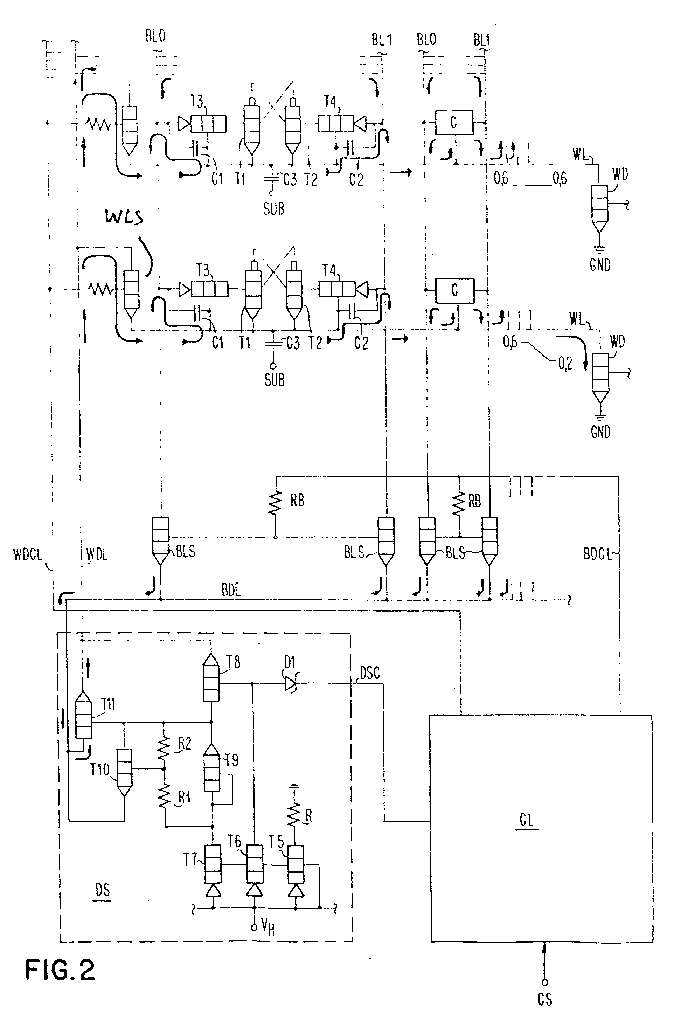

Um nun die Wort- und Bitleitungskapazitäten, dargestellt durch die Kapazitäten C1, C2 und C3, schnell entladen zu können und ohne das Auftreten von hohen Spitzenströmen durch die Wortleitungstreiber WD wird an Hand der Fig. 2, in der eine äußerst günstige Schaltung zum Entladen eines MTL-Halbleiterspeichers dargestellt ist, auch das erfindungsgemäße Entladeschema näher beschrieben.

In Fig. 2 ist eine MTL-Speicheranordnung beschrieben, die den Zellenaufbau nach Fig. 1 verwendet. Die Speicherzellen C sind wiederum im Schnittpunkt von Bitleitungspaaren BL0 und BL1 und Wortleitungen WI angeordnet. Die Wortleitungen WL sind auf der rechten Seite der Speicheranordnung wiederum mit den Worttreibern WD verbunden, die ihr Steuersignal von nicht dargestellten Decodierschaltkreisen erhalten. Auf der linken Seite ist jede Wortleitung WL mit einem Wortleitungs-Schalttransistor WLS, genauer gesagt mit dessen Emitter, verbunden. Die Basis eines Wortleitungs-Schalttransistors WLS ist über einen Widerstand RW mit einer Wortentladesteuerleitung WDCL verbunden. Diese Wortentladesteuerleitung WDCL ist ihrerseits mit einer Kontrollogik CL verbunden, die vom Chipauswahlsignal CS gesteuert wird und für das gesamte dargestellte Speicherplättchen die erforderlichen Zeit- und Steuerimpulse zur Verfügung stellt. Die Kollektoren der Wortleitungs-Schalttransistoren WLS sind mit einer Wortentladeleitung WDL verbunden, die ihrerseits mit einer von der Kontrollogik CL gesteuerten Entladeschaltung DS verbunden ist. Auf der Bitseite der Speicheranordnung sind in jeder Bitleitung BL0 und BL1 Bitleitungs-Schalttransistoren BLS angeordnet, die paarweise über Widerstände RB von einer gemeinsamen Bitentladesteuerleitung BDCL gesteuert werden, die ihrerseits mit der Kontrollogik CL verbunden ist. Die Emitter der Bitleitungs-Schalttransistoren BLS sind mit einer Bitentladeleitung BDL verbunden, die ihrerseits mit dem Eingang der Entladeschaltung DS verbunden ist. Bevor der Ablauf der Entladung in der Schaltung nach Fig. 2 beschrieben wird, soll zunächst noch die Schaltung der Entladeschaltung DS beschrieben werden.

Die Entladeschaltung DS besteht aus den als Stromquellen wirkenden PNP-Transistoren T5 bis T7, deren Eingangselektroden und Basiselektroden mit einer Spannungsversorgungsleitung VH verbunden sind. Die Ausgangselektrode des Transistors T5 ist über einen Widerstand R mit Masse verbunden, die Ausgangselektrode des Transistors T6 mit der Basis eines Steuertransistors T8 und die Ausgangselektrode des Transistors T7 ist mit der Eingangselektrode des Transistors T9 verbunden, der die Klemmreferenzspannung über einen Spannungsteiler R1 und R2, dem eigentlichen Klemm-Transistor T10 für den Schalttransistor T11 zur Verfügung stellt. Zu erwähnen ist noch, daß die Basis des Steuertransistors T8 über eine Schottky-Diode D1 mit der Kontrollogik CL verbunden ist und daß der Emitter des Steuertransistors T8 mit dem Emitter des Schalttransistors T11 und mit der Wortentladeleitung WDL verbunden ist. Die Bitentladeleitung BDL ist mit dem Kollektor des Schalttransistors T11 verbunden. Die Basis des Schalttransistors T11 ist mit dem Emitter des Transistors T9 und mit dem Kollektor des Steuertransistors T8 verbunden.

Im nachfolgenden wird nun beschrieben, wie die Entladeströme innerhalb der Speicheranordnung nach Fig. 2 verlaufen. Dazu wird zunächst angenommen, daß die Differenzspannung der Injektoren der Speicherzelltransistoren bei 0,4 V zwischen selektierter und nicht selektierter Speicherzelle liegt. Generell gesagt werden die Bitleitungskapazitäten über die Bitleitungs-Schalttransistoren BLS und über die Wortleitungs-Schalttransistoren WLS über die Entladeschaltung DS entladen. Im nachfolgenden wird nun der in Fig. 2 mit den Pfeilen eingezeichnete Stromverlauf erklärt.

Durch das Chip-Selektsignal CS gesteuert, werden die Bitleitungstransistoren BLS über die Bitentladungssteuerleitung BDCL und die Wortleitungstransistoren WLS über die Wortentladungssteuerleitung WDCL aktiviert, d. h. eingeschaltet. Die Kontrollogik CL gibt außerdem einen Steuerimpuls an den Entladeschaltkreis DS. Damit erfolgt die Entladung der Bitleitungskapazitäten. Danach wird die Wort- und Bitselektion eingeschaltet. Die Entladung der Bitleitungskapazitäten bewirkt, daß über die dargestellten Kapazitäten C1 und C2 der Speicherzellen ein Strom in die Bitleitungen BL0 und BL1 fließt. Dieser Strom fließt über die Bitleitungs-Schalttransistoren BLS auf die gemeinsame Bitentladeleitung BDL und von da über den Schalttransistor T11 in der Entladeschaltung DS auf die Wortentladeleitung WDL, von da über die Wortleitungs-Schalttransistoren WLS auf die Wortleitungen WL und von da aus verteilen sich die Ströme auf die Kapazitäten C1 und C2, dargestellt in den detailliert gezeichneten Speicherzellen. Damit ist der Stromkreis geschlossen. Wie bereits ausgeführt, wird zeitlich danach die Wort- und Bitleitungsselektion eingeschaltet, um eine bestimmte Wortleitung WL innerhalb der Speichermatrix auszuwählen. Vor dem Aktivieren des gewünschten Wortleitungstreibers WD (in Fig. 2 unten rechts) nach der erfolgten Auswahl durch die nicht dargestellten Decodierschaltkreise muß die Entladung der Bitleitungskapazitäten abgeschlossen sein, weshalb die Wort- und Bitleitungs-Schalttransistoren WLS und BLS vor Einschalten des bestimmten Wortleitungstreibers WD ausgeschaltet werden müssen. Anschließend kann nun eine bereits im Zusammenhang mit der Fig. 1 beschriebene Lese- oder Schreiboperation folgen.

Aus der Fig. 2 geht nun hervor, daß die Entladung der Bitleitungskapazitäten über die Bitleitungs-Schalttransistoren BLS, über einen einzigen gemeinsamen Entladeschalttransistor T11 mit Kollektor-Emitter-Spannungsstabilisierung und über die zusätzlichen Wortleitungs-Schalttransistoren WLS, die jeder Wortleitung WL zugeordnet sind, entladen werden.

Dabei führen die Bitleitungs-Schalttransistoren BLS jeweils nur den Anteil am kapazitiven Spitzenstrom, der von einer Bitleitung BL0 oder BL1 herrührt, d. h. mit anderen Worten, daß sie bei einem Speicher mit N Bitleitungspaaren und N Wortleitungen nur 1 durch 2N vom gesamten Spitzenstrom führen. Dadurch können diese Transistoren von ihrer Größe her als Minimumtransistoren ausgelegt werden. Für die Wortleitungs-Schalttransistoren WLS gilt die analoge Stromaufteilung, die damit ebenfalls als Minimumtransistoren ausgeführt werden können. Nur der in der Entladeschaltung DS enthaltene Entladeschalttransistor T11 muß für den gesamten Spitzenstrom ausgeführt werden. Die Ansteuerleistung für diesen Entladeschalttransistor T11 muß von einer solchen Größe sein, die ausreicht, um den gesamten Spitzenstrom zu treiben. Für die Bitleitungs-Schalttransistoren BLS und die Wortleitungs-Schalttransistoren WLS muß jeweils nur die Treiberleistung bereitgestellt werden, die ihrem Stromanteil entspricht.

Bei einem normal ausgeführten MTL-Speicherchip mit z. B. 50 Nanosekunden Zugriffszeit und 50 bis 100 Milliwatt Verlustleistung im unselektierten Fall ist der DC-GND-Strom wesentlich kleiner als der kapazitive Spitzenstrom, der über den Entladeschalttransistor T11 fließt. Fließt dieser Spitzenstrom nicht über die Spannungsversorgungsquellen, sondern wird er zur direkten Umladung der Bitleitungskapazitäten wie im vorliegenden Falle benutzt, so treten dadurch keine Störspannungsprobleme auf den Versorgungsspannungen auf. Die nicht selektierten Wortleitungen WL werden bei der Selektion einer Wortleitung mit vorhergehender Entladung der Bitleitungskapazitäten mit Hilfe des beschriebenen Entladeschemas und der gezeigten Entladeschaltung im Potential konstant gehalten. Die Schaltung kommt ohne eine niederohmige Referenzquelle, ohne Erhöhung der Wortleitungskapazitäten und ohne Erhöhung des Spannungshubs für die selektierten Wortleitungen aus. Die Folge ist, daß die elektrische Verlustleistung klein gehalten werden kann. Für das vorgeschlagene Selektionsschema genügt der minimale Spannungshub für die selektierte Wortleitung, der notwendig ist, um die Zellen, die an eine Bitleitung BL0 und BL1 angeschlossen sind, genügend voneinander zu entkoppeln. Der minimale Spannungshub ist von der Zahl der Zellen im Speicher und von deren Eingangskennlinie abhängig.

In Fig. 3 ist nun ein weiteres Ausführungsbeispiel mit einem für alle Bitleitungen gemeinsamen Entladeschaltkreis DS gezeigt. Der Unterschied zu Fig. 2 besteht jedoch darin, daß die Entladung der Bitleitungskapazitäten nicht über Wortleitungs-Schalttransistoren und damit über die Wortleitungen erfolgt, sondern direkt über den Entladeschaltkreis DS nach Masse GND. Zwecks Vereinfachung der Erklärung wird wieder der gleiche Aufbau der Speicherzellen angenommen wie in den Fig. 1 und 2. Der Entladevorgang für die Bitleitungskapazitäten wird in Fig. 3 wiederum bei der Selektion einer Wortleitung WL über den Wortleitungstreiber WD ausgeführt, der von nicht dargestellten Decodierschaltungen gesteuert wird. Die Differenzspannung für die Selektion zwischen selektierter und nicht selektierter Wortleitung beträgt ca. 0,4 V. Durch die kapazitive Kopplung wird die Spannung der nicht selektierten Wortleitung ca. 1/3 des Wortleitung-Spannungshubs der selektierten Wortleitung ausführen. Der Wortleitung-Spannungshub der selektierten Wortleitung liegt bei diesem Ausführungsbeispiel bei ca. 0,6 V. Die Standbypotentiale sind dabei: GND = 0 V, die Spannung auf den Wortleitungen 0,8 V und die Spannungen auf den Bitleitungen 1,4 V. Wenn eine Wortleitung der Speichermatrix selektiert ist, treten folgende Potentiale auf: Selektierte Wortleitung 0,2 V, nicht selektierte Wortleitung 0,6 V, Bitleitungen 1,0 V und die Injektorspannung ist bei der selektierten Zelle +0,8 V und bei den nicht selektierten Zellen +0,4 V. Auch hier muß wieder vor dem Auswählen einer Wortleitung WL die Entladung der Bitleitungskapazitäten erfolgen. Angeregt durch ein anliegendes Chipselektsignal CS gibt die Kontrollogik CL über die Leitung DSC ein Signal an die Entladeschaltung DS und an die Bitentladesteuerleitung BDCL ab. Damit kommt ein Stromfluß vom Substrat der Speichermatrix über die Kapazitäten C3, über die Wortleitungen WL, über die Kapazitäten C1 und C2 auf die Bitleitungen BL1 und BL0, von da über die Bitleitungs-Schalttransistoren BLS auf die gemeinsame Bitentladeleitung BDL über den Entlade-Schalttransistor T11 der Entladeschaltung DS nach Masse GND zustande. Bedingt durch die kapazitive Kopplung werden dabei die Spannungen auf den nicht selektierten Wortleitungen WL um 0,2 V in diesem Beispiel abgesenkt, während nach abgeschlossener Entladung die Spannung der durch den Wortleitungstreiber WD selektierten Wortleitung um 0,6 V abgesenkt wird. Der Aufbau der Entladeschaltung DS ist in Fig. 3 vereinfacht dargestellt, obwohl auch hier grundsätzlich die entsprechende Schaltung aus Fig. 2 verwendet werden kann. Der Vorteil der Schaltung nach Fig. 3 besteht gegenüber der in Fig. 2 dargestellten darin, daß keine Wortleitungs-Schalttransistoren mit zugehöriger Steuerleitung und Entladeleitung erforderlich sind. Die Transistoren der Wortleitungstreiber und die Bitleitungs-Schalttransistoren sind jedoch für höhere Ströme als in Fig. 2 zu konzipieren. Ist eine Umladung der Wortleitungskapazität C3 während der Umladung der Bitleitungskapazitäten C1 und C2 nicht erwünscht, so kann der dafür erforderliche Umladestrom von einer nicht dargestellten Referenzquelle in die Wortleitungen eingespeist werden. Die nicht selektierten Wortleitungen werden nicht umgeladen und für die Selektion ist nur der minimale Spannungshub der Wortleitung erforderlich.

Patentansprüche

1. Verfahren zum Betreiben eines Halbleiterspeichers mit Speicherzellen in MTL-Technik, die in Kreuzungspunkten von Wort- und Bitleitungen (WL und BL0, BL1) angeordnet sind und über Wortleitungstreiber (WD) und Dekodierer selektiert werden, wobei die Streukapazitäten (C1, C2) zwischen den Bitleitungen und den Wortleitungen zur Verringerung der Zugriffszeit und/oder des Leistungsbedarfs der Speicherzellen (C) entladen werden, dadurch gekennzeichnet, daß eine Kontrollogik (CL) bei Chipselektion gleichzeitig Steuersignale auf dem den Bitleitungen (BL0, BL1) verbundene Schalttransistoren (Fig. 3, BLS) und auf eine diesen Schalttransistoren nachgeschaltete gemeinsame Entladeschaltung (DS) abgibt, wodurch die Streukapazitäten über die Schalttransistoren und die Entladeschaltung nach einem Bezugspotential entladen werden, wonach die Wortselektion eingeschaltet wird.

2. Verfahren zum Betreiben eines Halbleiterspeichers mit Speicherzellen in MTL-Technik, die in Kreuzungspunkten von Wort- und Bitleitungen (WL und BL0, BL1) angeordnet sind und über Wortleitungstreiber (WD) und Decodierer selektiert werden, wobei die Streukapazitäten (C1, C2) zwischen den Bitleitungen und Wortleitungen zur Verringerung der Zugriffszeit und/oder des Leistungsbedarfs der Speicherzellen (C) entladen werden, dadurch gekennzeichnet, daß eine Kontrollogik (CL) bei Chipselektion gleichzeitig Steuersignale auf mit den Bitleitungen (BL0, BL1) verbundene Schalttransistoren (Fig. 2, BLS) und auf eine den Schalttransistoren (BLS) nachgeschaltete gemeinsame Entladeschaltung (DS) und ferner auf mit den Wortleitungen (WL) verbundene Wortleitungsschalttransistoren (WLS) abgibt, wodurch die Streukapazitäten über die Schalttransistoren (BLS), die Entladeschaltung (DS) und über die Wortleitungsschalttransistoren (WLS) entladen werden, wonach die Wortselektion eingeschaltet wird.

3. Schaltungsanordnung zur Durchführung des Verfahrens nach Anspruch 1, dadurch gekennzeichnet, daß insbesondere die Bitleitungen (BL0 und BL1) innerhalb einer Speichermatrix über die Schalttransistoren (BLS) mit einer Entladeleitung (BDL) verbunden sind, die ihrerseits mit der Entladeschaltung (DS) verbunden ist und daß die Entladeschaltung (DS) und alle Schalttransistoren (BLS) zur Steuerung über Leitungen (DSC, BDCL) mit der Kontrollogik (CL) verbunden sind, die mit dem Selektionssignal (CS) verbunden ist.

4. Schaltungsanordnung zur Durchführung des Verfahrens nach Anspruch 2, dadurch gekennzeichnet,
daß der Ausgang der Entladeschaltung (DS) mit einer Wortentladeleitung (WDL) verbunden ist,
daß mit dieser Leitung den Wortleitungen (WL) zugeordnete Wortleitungs-Schalttransistoren (WLS) verbunden sind, die über eine gemeinsame Steuerleitung (WDCL) mit der Steuerlogik (CL) verbunden sind und
daß die Bitleitungs-Schalttransistoren (BLS) auf eine gemeinsame Bitentladeleitung (BDL) führen, die mit dem Eingang der Entladeschaltung (DS) verbunden ist und
daß die Bitleitungs-Schalttransistoren außerdem mit der Bitentlade-Steuerleitung (BDCL) verbunden sind, die andererseits wie die Entladeschaltungs-Steuerleitung (DSC) mit der Kontrollogik (CL) verbunden ist.

5. Schaltungsanordnung nach Anspruch 4, dadurch gekennzeichnet, daß die Entladeschaltung (DS) aus einem Schalttransistor (T11) mit Kollektor-Emitter-Spannungsstabilisierung besteht.

6. Schaltungsanordnung nach Anspruch 5, dadurch gekennzeichnet, daß die Bitleitungs- und Wortleitungs-Schalttransistoren (BLS und WLS) als Minimum-Transistoren ausgeführt sind.

7. Schaltungsanordnung nach Anspruch 5, dadurch gekennzeichnet, daß die Wortleitungstreiber-Transistoren (WD) als Minimum-Transistoren ausgeführt sind.

**Claims**

1. Method of controlling a semiconductor memory with memory cells in MTL-technique which are arranged in intersections of word and bit lines (WL and BL0, BL1), and selected via word line drivers and decoders, the stray capacitances (C1, C2) between the bit lines and the word lines being discharged to reduce the access time and/or the power consumption of the memory cells (C), characterized in that upon chip selection a control logic (CL) simultaneously generates control signals onto switching transistors (Fig. 3, BLS) connected to the bit lines (BL0, BL1), and to a discharge circuit (DS) series-arranged to these switching transistors, so that the stray capacitances are discharged via the switching transistors and the discharge circuit to a reference potential, after which the word selection is switched on.

2. Method of controlling a semiconductor memory with memory cells in MTL-technique which are arranged in intersections of word and bit lines (WL and BL0, BL1) and selected via word line drivers (WD) and decoders, the stray capacitances (C1, C2) between the bit lines and word lines being discharged to reduce the address time and/or the power consumption of the memory cells (C), characterized in that upon chip selection a control logic (CL) simultaneously generates control signals to switching transistors (Fig. 2, BLS) connected to the bit lines (BL0, BL1), and to a common discharge circuit (DS) series-arranged with the switching transistors (BLS), and furthermore to word line switching transistors (WLS) connected to the word lines (WL), so that the stray capacitances are discharged via the switching transistors (BLS), the discharge circuit (DS), and via the word line switching transistors (WLS), after which the word selection is switched on.

3. Circuit arrangement for carrying out the method as claimed in claim 1, characterized in that particularly the bit lines (BL0 and BL1) within a memory matrix are connected via the switching transistors (BLS) to a discharge line (BDL) which in turn is connected to the discharge circuit (DS), and that the discharge circuit (DS) and all switching transistors are connected via lines (DSC, BDCL) to the control logic (CL) which is connected to the selection signal (CS).

4. Circuit arrangement for carrying out the method as claimed in claim 2, characterized in that the output of the discharge circuit (DS) is connected to a word discharge line (WDL), that connected to this word line switches (WLS) associated to the word lines (WL) are provided which via a common control line (WDCL) are connected to the control logic (CL), and that the bit line switches (BLS) lead to a common bit discharge line (BDL) connected to the input of the discharge circuit (WS), and that the bit line switches are also connected to the bit discharge control line (BDCL) which on the other hand like the discharge control line (DSC) is connected to the control logic (CL).

5. Circuit arrangement as claimed in claim 4, characterized in that the discharge circuit (DS) consists of a switching transistor (T11) with collector-emitter voltage stabilization.

6. Circuit arrangement as claimed in claim 5, characterized in that the bit line and word line switching transistors (BLS) and WLS) are minimum-area transistors.

7. Circuit arrangement as claimed in claim 5, characterized in that the word line driver transistors (WD) are minimum-area transistors.

**Revendications**

1. Procédé pour faire fonctionner une mémoire semiconductrice comportant des cellules de mémoire en technologie MTL disposées aux points d'intersection de lignes de mots et de bits (WL et BL0, BL1) et sélectées par des circuits d'attaque de lignes de mots (WD) et des décodeurs, les capacités parasites (C1, C2), situées entre les lignes de bits et les lignes de mots, étant déchargées pour diminuer le temps d'accès et/ou la puissance requise par les cellules de mémoire (C), caractérisé en ce que, pendant la sélection de la microplaquette, une logique de commande (CL) applique simultanément des signaux de commande sur les transistors de commutation (figure 3, BLS) connectés aux lignes de bits (BL0, BL1) et à un circuit de décharge (DS) commun connecté en série à ces transistors de commutation, ce qui a pour résultat que les capacités parasites sont déchargées, à travers les transistors de commutation et le circuit de décharge, vers un potentiel de référence, après quoi la sélection de mots est activée.

2. Procédé pour faire fonctionner une mémoire semiconductrice comportant des cellules de mémoire en technologie MTL disposées aux points d'intersection de lignes de mots et de bits (WL et BL0, BL1) et sélectionnées par des circuits d'attaque des lignes de mots (WD) et des décodeurs, les capacités parasites (C1, C2), situées entre les lignes de bits et les lignes de mots, étant déchargées pour diminuer le temps d'accès et/ou la puissance requise par les cellules de mémoire (C), caractérisé en ce que, pendant la sélection de la microplaquette, une logique de commande (CL) applique simultanément des signaux de commande sur les transistors de commutation (Figure 2, BLS) connectés aux lignes de bits (BL0, BL1), sur un

circuit de décharge commun (DS) connecté en séries aux transistors de commutation (BLS) et, de plus, sur des transistors de commutation de lignes de mots (WLS) connectés aux lignes de mots (WL), de telle sorte que les capacités parasites soient déchargées à travers les transistors de commutation (BLS), le circuit de décharge (DS) et à travers les transistors de commutation des lignes de mots (WLS), la sélection de mots est activée.

3. Circuit pour exécuter le procédé selon la revendication 1 caractérisé en ce que, en particulier, les lignes de bits (BL0 et BL1), dans la matrice de mémoire, sont connectées, à travers les transistors de commutation (BLS), à une ligne de décharge (BDL) connectée, à son tour, au circuit de décharge (DS) et en ce que le circuit de décharge (DS) et tous les transistors de commutation sont connectés, à travers des lignes (DSC, BDCL), à la logique de commande (CL) qui est elle-même connectée au signal de sélection (CS).

4. Circuit pour exécuter le procédé selon la revendication 2, caractérisé en ce que la sortie du circuit de décharge (DS) est connectée à une ligne de décharge de mots (WDL), en ce que les transistors de commutation des lignes de mots (WLS) associés aux lignes de mots (WL) sont connectés à cette ligne, lesdits transistors de commutation étant connectés à travers une ligne de commande commune (WDCL) à la logique de commande (CL) et en ce que les transistors de commutation de lignes de bits (BLS) sont dirigés sur une ligne de décharge de bits communes (BDL) connectée à l'entrée du circuit de décharge (DS), et en ce que les transistors de commutation de lignes de bits sont en outre connectés à la ligne de commande de décharge de bits (BDCL) qui, comme la ligne de commande du circuit de décharge (DSC), est connectée à la logique de commande (CL).

5. Circuit selon la revendication 4, caractérisé en ce que le circuit de décharge (DS) est composé d'un transistor de commutation (T11) ayant une tension émetteur-connecteur stabilisée.

6. Circuit selon la revendication 5, caractérisé en ce que les transistors de commutation des lignes de bits et des lignes de mots (BLS et WLS) sont des transistors à région minimale.

7. Circuit selon la revendication 6, caractérisé en ce que les transistors de circuit d'attaque des lignes de mots (WD) sont des transistors à région minimale.

FIG. 1

FIG. 3

FIG.2